# EUROPEAN PATENT SPECIFICATION

(11) **EP 3 247 008 B1**
(45) Date of publication and mention of the grant of the patent: **25.03.2020**
(21) Application number: 17170558.5
(22) Date of filing: 11.05.2017
(51) Int. Cl.: H01S 5/183, H01S 5/42, H01S 5/00, H01S 5/022, H01S 5/042, H01S 5/343, H01L 33/50, F21K 9/00, F21Y 105/10, F21Y 115/30

(54) **SURFACE EMITTING LASER DEVICE**
OBERFLÄCHENEMITTIERENDE LASERVORRICHTUNG
DISPOSITIF LASER À ÉMISSION PAR LA SURFACE

(30) Priority: 12.05.2016 JP 2016095951
(43) Date of publication of application: 22.11.2017
(73) Proprietor: STANLEY ELECTRIC CO., LTD., Tokyo 153-8636 (JP)
(72) Inventor: TAZAWA, Komei, Tokyo, 153-8636 (JP); LIANG, Ji-Hao, Tokyo, 153-8636 (JP)
(74) Representative: Carstens, Dirk Wilhelm

(56) References cited:
- EP-A2- 2 325 957
- US-A1- 2008 013 329
- US-A1- 2013 329 440
- US-A1- 2015 076 529

## Description

### BACKGROUND OF THE INVENTION

### 1. Field of the Invention

The present invention relates to a surface emitting laser device including a vertical cavity surface emitting laser (VCSEL).

### 2. Description of the Related Art

The vertical cavity surface emitting laser (hereinafter referred to simply as a surface emitting laser) is a semiconductor laser having a structure for causing light to resonate vertically to a substrate surface and causing the light to exit in a direction vertical to the substrate surface. A light-emitting device including a plurality of semiconductor light-emitting elements, such as surface emitting lasers, arranged in an array has been known in the art. For example, JP 2009-134965 A discloses a lighting device including: a plurality of light-emitting elements mounted on a substrate; a frame provided with a through hole; and a fluorescent filter plate arranged in the through hole.

US 2008/013329 A1 discloses a lamp for a vehicle and was used as a basis for the preamble of claim 1.

### SUMMARY OF THE INVENTION

In a light-emitting device in which a plurality of light-emitting elements are arranged side by side, for example, it is desirable that crosstalk of light, i.e., light emitted from one of the elements traveling on an optical path of another one of the elements (for example, an element being turned off) be reduced as much as possible in view of individually driving the plurality of light-emitting elements. When the elements are driven, on the other hand, it is desirable that the formation of a dark line corresponding to a non-light-emitting region between elements adjacent to each other be reduced as much as possible.

While the surface emitting laser is a high-power light-emitting element capable of forming an array in a space-saving manner, reduction in the above-described crosstalk and dark line is preferably encouraged also in an arrayed surface emitting laser device. Moreover, the surface emitting laser device has an amount of heat generation larger than that of a light-emitting diode (LED), for example. Thus, it is desirable for the surface emitting laser device to have a high heat dissipation performance.

The present invention has been made in view of the above-described problems. It is an object of the present invention to provide a surface emitting laser device including a plurality of surface emitting laser elements and capable of significantly reducing the crosstalk of light and the formation of the dark line. It is another object of the present invention to provide a surface emitting laser device including a plurality of surface emitting laser elements and having a high heat dissipation performance.

A surface emitting laser device according to the present invention is provided as set forth in claim 1. Preferred embodiments of the present invention may be gathered from the dependent claims.

### BRIEF DESCRIPTION OF THE DRAWINGS

FIG. 1A is a perspective view schematically illustrating a surface emitting laser device according to a first embodiment, and FIG. 1B is a cross-sectional view of the surface emitting laser device according to the first embodiment;
FIG. 2A is a cross-sectional view illustrating a light-emitting segment in the surface emitting laser device according to the first embodiment, and FIG. 2B is a diagram schematically showing paths of light in the light-emitting segment; and
FIG. 3 is a cross-sectional view illustrating a surface emitting laser device according to a second embodiment.

### DETAILED DESCRIPTION OF THE INVENTION

Embodiments of the present invention will now be described below in detail.

### [First Embodiment]

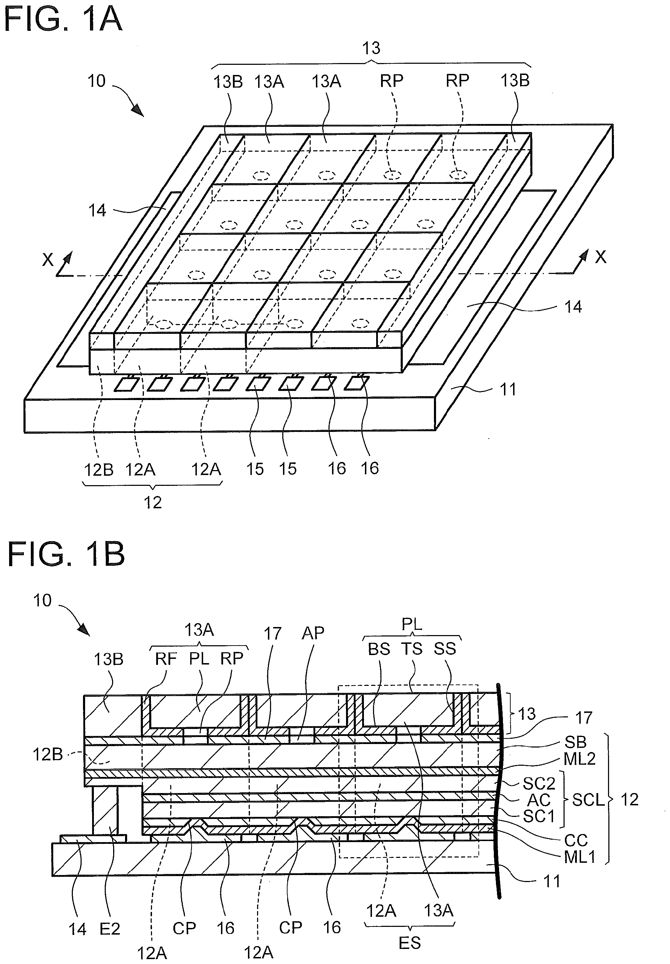

FIG. 1A is a perspective view schematically illustrating a surface emitting laser device (hereinafter referred to simply as a laser device) 10 according to the first embodiment. The surface emitting laser device 10 has a surface emitting laser array (hereinafter referred to simply as a laser array) 12 including a plurality of vertical cavity surface emitting laser (VCSEL) elements (hereinafter referred to simply as surface emitting laser elements or laser elements) 12A arranged side by side on a mounting substrate 11. For the sake of clarity in the figure, only some of the laser elements 12A are shown in FIG. 1A.

The laser device 10 has a wavelength converter 13 provided on the laser array 12 and including a plurality of wavelength conversion plates 13A corresponding to the respective laser elements 12A. Each of the wavelength conversion plates 13A has a light receiving part RP configured to receive light outputted from a corresponding one of the laser elements 12A. The wavelength conversion plate 13A performs wavelength conversion on light having entered thereinto via the light receiving part RP. In the present embodiment, the light receiving part RP is provided on one of principal surfaces of the wavelength conversion plate 13A, and light having entered into the wavelength conversion plate 13A is extracted from the other one of the principal surfaces of the wavelength conversion plate 13A.

In the present embodiment, the laser device 10 includes sixteen laser elements 12A arranged in a matrix of four rows × four columns, and sixteen wavelength conversion plates 13A formed on the laser elements 12A and arranged in a matrix of four rows × four columns. In the present embodiment, the laser elements 12A are integrally formed, and the wavelength conversion plates 13A are integrally formed.

The laser device 10 also includes a common terminal 14 connected to the respective laser elements 12A, and individual terminals 15 connected to the laser elements 12A, respectively. The individual terminals 15 are individually connected to the laser elements 12A via wiring electrodes 16. Each of the laser elements 12A performs a light-emitting operation by applying voltage between the common terminal 14 and the individual terminal 15 corresponding to that laser element 12A. In the present embodiment, the individual terminals 15 are insulated from one another, thereby allowing each of the laser elements 12A to perform the light-emitting operation independently.

In the present embodiment, the laser array 12 includes a connection region 12B with respect to the common terminal 14 on a side of the outermost laser element 12A. The wavelength converter 13 includes a side plate 13B provided on the connection region 12B. In the present embodiment, each of the laser array 12 and the wavelength converter 13 has a rectangular top surface shape. The common terminal 14 is provided in each of both sides of the laser array 12 opposed to each other on the mounting substrate 11. The connection regions 12B are provided on both sides of the laser array 12 to interpose the laser elements 12A therebetween. Only one of the connection regions 12B is shown in FIG. 1A.

FIG. 1B is a cross-sectional view of the laser device 10. While FIG. 1B is a cross-sectional view taken along line X-X in FIG. 1A, FIG. 1B shows a partial view thereof. As shown in FIG. 1B, the laser array 12 includes a semiconductor structure layer SCL, which is common to the laser elements 12A, and first and second multilayer reflecting mirrors (hereinafter referred to simply as reflecting mirrors) ML1 and ML2 opposed to each other with the semiconductor structure layer SCL interposed therebetween.

In the present embodiment, the semiconductor structure layer SCL includes an active layer AC, and first and second semiconductor layers SC1 and SC2 formed with the active layer AC interposed therebetween. The semiconductor structure layer SCL has a composition of AlₓIn_{y}Ga_{1-x-y}N (0 ≤ x ≤ 1, 0 ≤ y ≤ 1, 0 ≤ x + y ≤ 1), for example. In the present embodiment, the active layer AC has a multiple quantum well structure.

In the present embodiment, the first semiconductor layer SC1 is a p-type semiconductor layer, and the second semiconductor layer SC2 is an n-type semiconductor layer. The individual terminal 15 is connected to the first semiconductor layer SC1 via the wiring electrode 16, whereas the common terminal 14 is connected to the second semiconductor layer SC2 via a connecting electrode (second connecting electrode) E2. The connecting electrode E2 is electrically insulated from the first semiconductor layer SC1, the active layer AC, and the wiring electrodes 16.

In the present embodiment, the first reflecting mirror ML1 is a distributed Bragg reflector (DBR) in which dielectric layers having refractive indexes different from each other are alternately layered. The second reflecting mirror ML2, on the other hand, is a DBR in which semiconductor layers having refractive indexes different from each other are alternately layered.

The laser array 12 includes a current confinement layer CC formed between the semiconductor structure layer SCL and the first reflecting mirror ML1 and having current confinement parts CP corresponding to the respective laser elements 12A. The current confinement layer CC is an insulating layer made of an insulating material, such as SiO₂ or SiN, for example, and includes openings (first openings) as the current confinement parts CP.

In the present embodiment, the laser array 12 includes a semiconductor substrate SB common to the laser elements 12A. The laser array 12 has a structure in which the second reflecting mirror ML2, the second semiconductor layer SC2, the active layer AC, the first semiconductor layer SC1, the current confinement layer CC, and the first reflecting mirror ML1 are laminated on the semiconductor substrate SB. The laser device 10 has a structure in which the first reflecting mirror ML1 side of the laser array 12 is flip-chip mounted on the mounting substrate 11. Note that the mounting substrate 11 is made of a material having a high heat conductivity, such as Si, AlN, or SiC, for example.

A light absorption layer 17 is formed on the laser array 12. The wavelength converter 13 is fixed onto the laser array 12 via the light absorption layer 17. The light absorption layer 17 includes a metal layer with a low reflectivity, for example. The light absorption layer 17 includes an opening (second opening) AP as a light passage part on each of the laser elements 12A.

Each of the wavelength conversion plates 13A in the wavelength converter 13 includes: a fluorescent plate PL having a bottom surface BS, a top surface TS, and side surfaces SS; and a light reflection film RF covering the bottom surface BS and the side surfaces SS of the fluorescent plate PL and having an opening (third opening) as the light receiving part RP in the bottom surface BS. The fluorescent plate PL is composed of a glass plate containing fluorescent particles and light scattering particles, for example. The wavelength conversion plate 13A is fixed to the laser element 12A (laser array 12) via the light reflection film RF on the bottom surface BS and the light absorption layer 17. In the present embodiment, the wavelength conversion plates 13A are bonded to a surface of the semiconductor substrate SB of the laser array 12.

In the present embodiment, the opening (first opening) of the current confinement layer CC as the current confinement part CP, the opening (second opening) of the light absorption layer 17 as the light passage part AP, and the opening (third opening) of the light reflection film RF as the light receiving part RP each have a circular shape, and are arranged coaxially in a direction perpendicular to the mounting substrate 11. The fluorescent plate PL has a rectangular shape as viewed from above. The light receiving part (opening) RP is arranged at the center of the bottom surface BS of the fluorescent plate PL. The shapes of the openings CP, AP, and RP are not limited to circular shapes, but may be elliptical or polygonal shapes, for example. Also, the top surface shape of the fluorescent plate PL is not limited to a rectangular shape, but may be a circular or polygonal shape, for example.

Each of the wiring electrodes 16 is connected to the semiconductor structure layer SCL (the first semiconductor layer SC1 in the present embodiment) corresponding to the positions of the current confinement part CP (first opening), the light passage part (second opening) AP, and the light receiving part RP (third opening). Current applied between the common terminal 14 and one of the individual terminals 15 (wiring electrodes 16) flows through the semiconductor structure layer SCL via a corresponding one of the current confinement parts CP.

Light emitted in the active layer AC causes laser oscillation by being amplified between the first and second reflecting mirrors ML1 and ML2, passes through the light passage part AP, and then enters into the wavelength conversion plate 13A from the light receiving part RP (the bottom surface BS of the fluorescent plate PL) disposed directly above the current confinement part CP. The light having entered into the wavelength conversion plate 13A undergoes the conversion of its wavelength, and then exits from the top surface TS. In this manner, one laser element 12A and its corresponding wavelength conversion plate 13A together constitute one light-emitting segment ES. The laser device 10 has a configuration capable of individually driving each of the light-emitting segments ES.

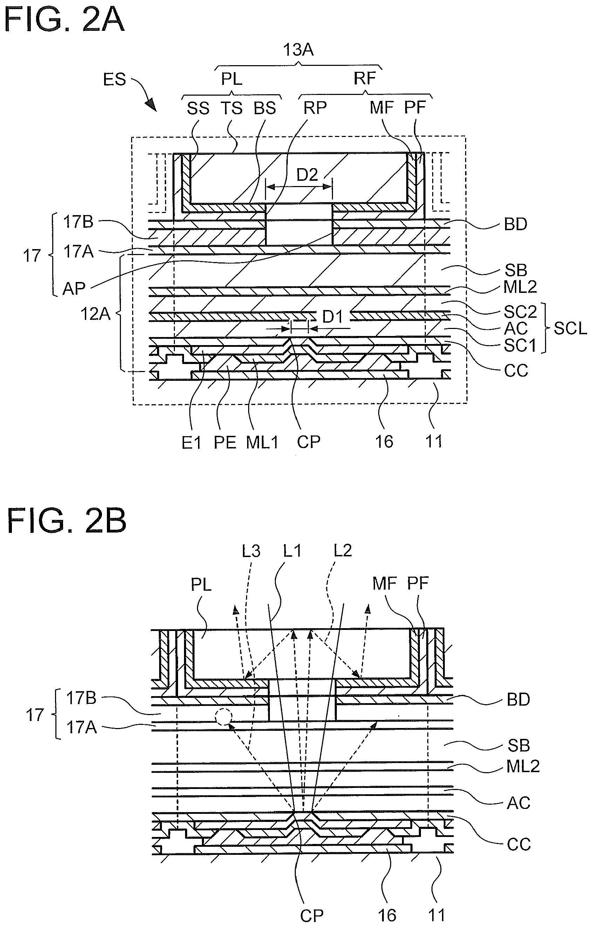

FIG. 2A is a cross-sectional view illustrating a more detailed structure of the light-emitting segment ES. While FIG. 2A is a partial enlarged cross-sectional view showing a portion surrounded by a broken line in FIG. 1B in an enlarged manner, part of the hatching is omitted and part of the components is shown with a broken line. FIG. 2A is used to describe the configuration of the laser element 12A and the wavelength conversion plate 13A in more detail.

The laser element 12A has a connecting electrode (first connecting electrode) E1 connected to a surface of the first semiconductor layer SC1 exposed from the opening CP. The connecting electrode E1 is formed on the current confinement layer CC while embedding the opening CP. The connecting electrode E1 is made of a transparent material such as ITO or IZO, for example.

The first reflecting mirror ML1 is formed on the connecting electrode E1 and has through holes partially exposing the connecting electrode E1. The laser element 12A has a pad electrode PE connected to the connecting electrode E1 via the through holes. The pad electrode PE is formed on the first reflecting mirror ML1 while embedding the through holes. The wiring electrode 16 is in contact with the pad electrode PE.

In the present embodiment, the wavelength conversion plate 13A has the light reflection film RF having a two-layer structure. The light reflection film RF is comprised of a reflective metal film MF formed on the side surfaces SS and the bottom surface BS of the fluorescent plate PL, and a protective metal film PF formed on the reflective metal film MF. The reflective metal film MF has a structure in which any of Ti/Ag, Ti/Al, and ITO/Ag thin films is laminated in this order, for example. The protective metal film PF has a structure in which a Ti film, a Pt film, and an Au film are laminated, for example.

The light absorption layer 17 includes an antireflection layer 17A formed on the laser element 12A, and an absorption layer 17B formed on the antireflection layer 17A to function as a light absorption layer. In other words, the light absorption layer 17 includes the antireflection layer 17A at the interface with the laser element 12A. In the present embodiment, the antireflection layer 17A is formed also in the opening (light passage part) AP on the laser element 12A. In the present embodiment, the light passage part AP of the light absorption layer 17 is composed of the antireflection layer 17A, and an opening of the absorption layer 17B provided on the antireflection layer 17A.

The antireflection layer 17A is formed from a dielectric multilayer film in which any one of an SiO₂ layer, an Nb₂O₅ layer, a ZrO₂ layer, an Al₂O₃ layer, and the like is laminated in a plurality of times, for example. The antireflection layer 17A can be formed, for example, by adjusting a layer thickness of each of the dielectric layers so as to be antireflective against the wavelength of the light emitted from the active layer AC. The absorption layer 17B functioning as the light absorption layer 17 includes a low-reflective metal layer, such as layered Cu or diamond-like carbon (DLC), for example.

In the present embodiment, the opening AP of the light absorption layer 17 (absorption layer 17B) has the same opening diameter as the opening RP of the light reflection film RF. Note however that the relationship between the opening diameters of the openings AP and RP is not limited thereto. It is only necessary that the opening RP is arranged on the opening AP.

The laser element 12A and the wavelength conversion plate 13A are bonded to each other via a bonding metal layer BD. In the present embodiment, the semiconductor substrate SB of the laser element 12A and the protective metal film PF of the wavelength conversion plate 13A are bonded to each other via the light absorption layer 17 and the bonding metal layer BD. More specifically, the light absorption layer 17 and the bonding metal layer BD are formed in this order on the semiconductor substrate SB, and the protective metal film PF is bonded to the bonding metal layer BD.

Note that the bonding metal layer BD has a structure in which a Ti film or an Ni film, a Pt film, and an Au film, for example, are laminated. In the present embodiment, the bonding metal layer BD has an opening having the same diameter as, and arranged coaxially with, the openings AP and RP.

Adjacent wavelength conversion plates 13A of the wavelength converter 13 are in contact with each other via the light reflection film RF on the side surface SS of the fluorescent plate PL. In the present embodiment, the wavelength conversion plate 13A is bonded (fixed) to its adjacent another wavelength conversion plate 13A via the protective metal film PF of the light reflection film RF over the side surface SS of the fluorescent plate PL, thereby constituting the integral plate-shaped wavelength converter 13 as a whole. An interval between the side surfaces SS of the fluorescent plates PL is about several µm, for example.

In the present embodiment, an opening diameter D2 of the opening AP of the light absorption layer 17 and the opening RP of the light reflection film RF has a dimension larger than or equal to an opening diameter D1 of the opening CP of the current confinement layer CC (insulating layer) functioning as a contact part between the semiconductor structure layer SCL of the laser element 12A and the connecting electrode E1. The opening diameters D1 and D2 can be adjusted in consideration of the entire layer thickness of the laser element 12A, the distance between the openings CP and RP, and a beam divergence angle in the opening RP, for example. In view of the light extraction efficiency, the opening diameter D2 is preferably larger than or equal to the opening diameter D1.

The outer shape and thickness of the fluorescent plate PL can be adjusted to obtain a desired emission color by taking into consideration the material of the semiconductor structure layer SCL or the material of the fluorescent particles, for example. For example, the opening CP has an opening diameter D1 of 2 to 20 µm, and the opening RP has an opening diameter D2 of 20 to 40 µm. For example, the fluorescent plate PL has a thickness of 20 to 300 µm, and a width and a length of 50 to 400 µm.

FIG. 2B is a diagram schematically showing paths of light in the light-emitting segment ES. FIG. 2B is a cross-sectional view similar to FIG. 2A. First, since large part of laser light outputted from the laser element 12A has a coherent property, such major coherent light L1 goes straight toward the opening AP and the opening RP and enters into the fluorescent plate PL.

In the present embodiment, the antireflection layer 17A is provided on an exit part (within the light passage part AP in the light absorption layer 17) of the light L1 in the laser element 12A. Thus, the reflection of the light L1 on the top surface of the laser element 12A is suppressed. This enables most of the light L1 to exit from the laser element 12A (pass through the light absorption layer 17) and then enter into the fluorescent plate PL.

The light L1 having entered into the fluorescent plate PL partially collides against the fluorescent particles and the light scattering particles in the fluorescent plate PL. Resultant wavelength-converted light or scattered light is outputted from the top surface TS. The light L1 that has not collided against the fluorescent particles or the like directly goes straight and exits from the top surface TS of the fluorescent plate PL. This causes the color mixture of the light, thus enabling light with the desired emission color to be obtained.

Of the light L1, light L2 reflected by the top surface TS travels toward the bottom surface BS of the fluorescent plate PL. The light L2 is reflected by the light reflection film RF (reflective metal film MF) almost entirely covering the bottom surface BS and the side surfaces SS except for the opening RP. Thus, the light L2 again travels toward the top surface TS and is more likely to be extracted from the fluorescent plate PL. Moreover, the provision of the light reflection film RF on the side surfaces SS can prevent the light L1 and L2 from traveling into another fluorescent plate PL. Therefore, the light having entered into the wavelength conversion plate 13A can be extracted to the outside while suppressing crosstalk.

Light emitted from the laser element 12A may contain a component without the coherent property as in light emitted from a light-emitting diode, for example. Since such incoherent light L3 is emitted in a radiating manner from the active layer AC, there is a possibility of traveling in a direction deviated from the opening RP. Such light L3, however, is more likely to enter into the light absorption layer 17 and disappear or attenuate in the light absorption layer 17. Thus, the light L3 entering into the region of another light-emitting segment ES, i.e., the crosstalk of the light can be reduced.

In the present embodiment, the light absorption layer 17 includes the antireflection layer 17A at the interface with the laser element 12A. Thus, the light L3 can be prevented from being reflected by the light absorption layer 17. Therefore, the light L3 can be prevented from being brought back to the laser element 12A side, straying within the element, and then traveling into the region of another laser element 12A. Thus, the crosstalk of light can be significantly reduced.

In the present embodiment, the light absorption layer 17 having the opening (light passage part) AP is first formed on the laser element 12A as mentioned above. The wavelength conversion plate 13A including the fluorescent plate PL having the side surfaces SS covered with the light reflection film RF is formed on the light absorption layer 17. Thus, the high-power laser device 10 capable of reducing the crosstalk of light can be provided.

In the present embodiment, the light reflection film RF covers the bottom surface BS of the fluorescent plate PL while having the opening RP. Thus, light can be caused to enter into the wavelength conversion plate 13A with high efficiency while utilizing the characteristics of laser light, and the light can be extracted from the wavelength conversion plate 13A with high efficiency.

The fluorescent plate PL of the wavelength conversion plate 13A is in contact with another fluorescent plate PL via the light reflection film RF. Thus, a region having a possibility of forming a non-light-emitting region between the light-emitting segments ES, i.e., a dark line, can be confined to the extent of the thickness of the light reflection film RF. For example, a distance between the fluorescent plates PL can be reduced to about 5 to 20 µm. Thus, the formation of the dark line corresponding to the region between the fluorescent plates PL can be reduced.

Thus, when the laser device 10 is used for lighting purposes, for example, a high contrast can be achieved in an irradiated region. Moreover, the formation of the dark line can be reduced in the irradiated region, thereby enabling the uniform lighting of the entire irradiated region. Thus, the surface emitting laser device 10 capable of significantly reducing the crosstalk of light and the formation of the dark line can be provided.

The light reflection film RF in the wavelength conversion plate 13A is in contact with the bonding metal layer BD. The bonding metal layer BD and the light reflection film RF together form a heat dissipation path for dissipating heat generated in the wavelength conversion plate 13A to the outside. Moreover, since the bottom surface of the wavelength conversion plate 13A is almost entirely in contact with the bonding metal layer BD except for the opening RP as mentioned above, heat dissipation can be performed with high efficiency.

The light reflection film RF including the reflective metal film MF and the protective metal film PF can improve the durability of the light reflection film RF and form the stable heat dissipation part together with the bonding metal layer BD. Thus, the surface emitting laser device 10 including the plurality of surface emitting laser elements 12A and having a high heat dissipation performance can be obtained.

In the surface emitting laser, a large amount of heat is generated on the exit surface of laser light or in the opening RP of the wavelength conversion plate 13A, for example. In addition, when a plurality of the laser elements 12A are arranged in an array, the generated heat may have difficulty in escaping to the outside. In the present embodiment, in contrast, heat dissipation can be performed with high efficiency by utilizing the bonding metal layer BD and the light reflection film RF. Thus, the highly-reliable and long-life laser device 10 can be provided.

While the laser array 12 includes the connection region 12B and the wavelength converter 13 includes the side plate 13B in the present embodiment, it is only necessary for the laser array 12 and the wavelength converter 13 to have the plurality of laser elements 12A and the plurality of wavelength conversion plates 13A, respectively. While the laser elements 12A are connected in parallel and configured to be capable of being individually driven in the present embodiment, the connection configuration of the laser elements 12A is not limited thereto. For example, the laser elements 12A may be connected in series.

While the laser elements 12A and the wavelength conversion plates 13A are arranged in a matrix in the present embodiment, such an arrangement configuration of the laser elements 12A and the wavelength conversion plates 13A is provided by way of example only. It is only necessary for the laser device 10 that the laser array 12 including the plurality of laser elements 12A is formed on the mounting substrate 11. For example, the laser elements 12A may be arranged in a honeycomb shape. The above-described arrangement configuration of the wavelength conversion plates 13A and the above-described layer configuration of the laser element 12A are provided by way of example only.

While the light reflection film RF is formed on the bottom surface BS of the fluorescent plate PL in the present embodiment, it is only necessary that the light reflection film RF is formed on the side surfaces SS of the fluorescent plate PL. The side surfaces SS and most part of the bottom surface BS of the fluorescent plate PL serve as a light reflecting surface or a light absorbing surface due to the light absorption layer 17 and the light reflection film RF on the side surfaces SS. Thus, the crosstalk of light can be reduced.

While the light absorption layer 17 is composed of the antireflection layer 17A and the absorption layer 17B in the present embodiment, it is only necessary that the light absorption layer 17 includes the absorption layer 17B. The antireflection layer 17A does not necessarily need to be provided.

In the present embodiment, the laser device 10 includes: the plurality of laser elements 12A arranged in an array; the light absorption layer 17 formed on each of the laser elements 12A and having the opening AP; and the wavelength conversion plate 13A formed on the light absorption layer 17 and having the fluorescent plate PL and the light reflection film RF covering the side surfaces SS of the fluorescent plate PL. Thus, the high-power arrayed surface emitting laser device 10 capable of reducing the crosstalk of light and the formation of the dark line can be provided.

### [Second Embodiment]

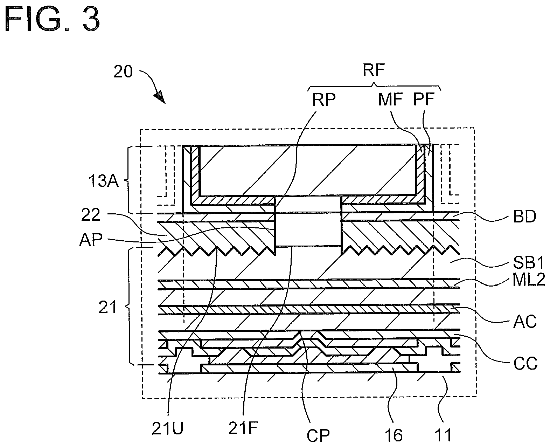

FIG. 3 is a cross-sectional view illustrating a surface emitting laser device 20 according to a second embodiment. FIG. 3 is a cross-sectional view showing one light-emitting segment of the laser device 20 in an enlarged manner. The laser device 20 has the same configuration as the laser device 10 except for configurations of a laser element 21 and a light absorption layer 22. In the present embodiment, each of the laser elements 21 has a top surface shape including a flat surface 21F and an uneven surface 21U. The light absorption layer 22 is formed on the uneven surface 21U while having an opening AP on the flat surface 21F.

For example, the uneven surface 21U can be formed on a surface of a semiconductor substrate SB1 by subjecting the semiconductor substrate SB1 of the laser element 21 to etching except for a portion thereof (portion to be the flat surface 21F) so as to form a plurality of hexagonal pyramid protrusions coming from the crystal structure of a GaN-based semiconductor, for example. The light absorption layer 22 is then formed on the uneven surface 21U. The layer configuration of the light absorption layer 22 is the same as that of the light absorption layer 17.

In the present embodiment, the laser element 21 has the uneven surface 21U at the interface with the light absorption layer 22. Thus, light traveling toward the light absorption layer 22 (light such as the light L3 in FIG. 2B) can be caused to enter into the light absorption layer 22 with high efficiency. This can enable large part of the light traveling toward the light absorption layer 22 to disappear or attenuate, thereby reducing the crosstalk of the light. Thus, the high-power laser device 20 capable of reducing the crosstalk of light and reducing the formation of the dark line can be provided.

## Claims

1. A surface emitting laser device (10) comprising:
a mounting substrate (11);
a surface emitting laser array (12) including a plurality of surface emitting laser elements (12A) arranged side by side on the mounting substrate (11);
a plurality of light absorption layers (17) formed on the plurality of surface emitting laser elements (12A), respectively, and each including an opening (AP); and
a plurality of wavelength conversion plates (13A) formed on the plurality of light absorption layers (17), respectively, and each including a fluorescent plate (PL) and a light reflection film (RF) covering a side surface of the fluorescent plate (PL);
**characterized in that**
the light absorption layer (17) includes an antireflection layer (17A) at an interface with the surface emitting laser element (12A).

2. The surface emitting laser device according to claim 1, wherein the surface emitting laser element (12A) includes an uneven surface at an interface with the light absorption layer (17).

3. The surface emitting laser device according to claim 1 or 2, wherein the light reflection film (RF) is formed between the light absorption layer (17) and the fluorescent plate (PL).

4. The surface emitting laser device according to any one of claims 1 to 3, wherein adjacent wavelength conversion plates of the plurality of wavelength conversion plates (13A) are in contact with each other via the light reflection film (RF) on the side surface of the fluorescent plate (PL).

5. The surface emitting laser device according to any one of claims 1 to 4, wherein the surface emitting laser array (12) comprises:
a semiconductor structure layer (SB) that is common to the surface emitting laser elements (12A);
first and second multilayer reflecting mirrors (ML1, ML2) opposed to each other with the semiconductor structure layer (SB) interposed therebetween; and
a current confinement layer (CC) formed between the first multilayer reflecting mirror (ML1) and the semiconductor structure layer (SB) and including a plurality of current confinement parts (CP) corresponding to the surface emitting laser elements (12A), respectively.

6. The surface emitting laser device according to claim 5, wherein:
the current confinement layer (CC) is an insulating layer including an opening as the current confinement part (CP); and
the opening of the insulating layer is arranged coaxially with the opening (AP) of the light absorption layer (17).

7. The surface emitting laser device according to claim 6, wherein the opening (AP) of the light absorption layer (17) has an opening diameter greater than or equal to an opening diameter of the opening of the insulating layer.

## Patentansprüche

1. Oberflächenemitter-Laservorrichtung (10), die Folgendes aufweist:
ein Befestigungssubstrat (11);
eine Oberflächenemitter-Laseranordnung (12), die eine Vielzahl von Oberflächenemitter-Laserelementen (12A) aufweist, die Seite an Seite auf dem Befestigungssubstrat (11) angeordnet sind;
eine Vielzahl von Lichtabsorptionsschichten (17), die auf der Vielzahl der jeweiligen Oberflächenemitter-Laserelemente (12A) geformt sind, und wobei jede eine Öffnung (AP) aufweist; und
eine Vielzahl von Wellenlängenumwandlungsplatten (13A), die auf der Vielzahl der jeweiligen Lichtabsorptionsschichten (17) geformt sind, und wobei jede eine fluoreszierende Platte (PL) und einen Lichtreflexionsfilm (RF) aufweist, der eine Seitenfläche der fluoreszierenden Platte (PL) bedeckt;
**dadurch gekennzeichnet, dass**
die Lichtabsorptionsschicht (17) eine Antireflexionsschicht (17A) an einer Schnittstelle zu dem Oberflächenemitter-Laserelement (12A) aufweist.

2. Oberflächenemitter-Laservorrichtung nach Anspruch 1, wobei das Oberflächenemitter-Laserelement (12A) eine unebene Oberfläche an einer Schnittstelle zu der Lichtabsorptionsschicht (17) aufweist.

3. Oberflächenemitter-Laservorrichtung nach Anspruch 1 oder 2, wobei der Lichtreflexionsfilm (RF) zwischen der Lichtabsorptionsschicht (17) und der fluoreszierenden Platte (PL) geformt ist.

4. Oberflächenemitter-Laservorrichtung nach einem der Ansprüche 1 bis 3, wobei benachbarte Wellenlängenumwandlungsplatten der Vielzahl von Wellenlängenumwandlungsplatten (13A) über den Lichtreflexionsfilm (RF) an der Seitenfläche der fluoreszierenden Platte (PL) in Kontakt miteinander sind.

5. Oberflächenemitter-Laservorrichtung nach einem der Ansprüche 1 bis 4, wobei die Oberflächenemitter-Laseranordnung (12) Folgendes aufweist:
eine Halbleiterstrukturschicht (SB), die gemeinsam für die Oberflächenemitter-Laserelemente (12A) ist;
erste und zweite mehrlagige reflektierende Spiegel (ML1, ML2), die einander gegenüberliegen, wobei die Halbleiterstrukturschicht (SB) dazwischen angeordnet ist; und
eine Strombegrenzungsschicht (CC), die zwischen dem ersten mehrlagigen reflektierenden Spiegel (ML1) und der Halbleiterstrukturschicht (SB) geformt ist und eine Vielzahl von Strombegrenzungsteilen (CP) aufweist, die jeweils den Oberflächenemitter-Laserelementen (12A) entsprechen.

6. Oberflächenemitter-Laservorrichtung nach Anspruch 5, wobei die Strombegrenzungsschicht (CC) eine isolierende Schicht ist, die eine Öffnung als den Strombegrenzungsteil (CP) aufweist; und
die Öffnung der isolierenden Schicht koaxial mit der Öffnung (AP) der Lichtabsorptionsschicht (17) angeordnet ist.

7. Oberflächenemitter-Laservorrichtung nach Anspruch 6, wobei die Öffnung (AP) der Lichtabsorptionsschicht (17) einen Öffnungsdurchmesser hat, der größer als der oder gleich dem Öffnungsdurchmesser der Öffnung der isolierenden Schicht ist.

## Revendications

1. Dispositif laser à émission de surface (10) comprenant :
un substrat de montage (11) ;
un réseau laser à émission de surface (12) comportant une pluralité d'éléments laser à émission de surface (12A) disposés côte à côte sur le substrat de montage (11) ;
une pluralité de couches d'absorption de lumière (17) formées sur la pluralité d'éléments laser à émission de surface (12A), respectivement, et chacune comportant une ouverture (AP) ; et
une pluralité de plaques de conversion de longueur d'onde (13A) formées sur la pluralité de couches d'absorption de lumière (17), respectivement, et chacune comportant une plaque fluorescente (PL) et un film de réflexion de lumière (RF) couvrant une surface latérale de la plaque fluorescente (PL) ;
**caractérisé en ce que**
la couche d'absorption de lumière (17) comporte une couche antireflet (17A) au niveau d'une interface avec l'élément laser à émission de surface (12A).

2. Dispositif laser à émission de surface selon la revendication 1, dans lequel l'élément laser à émission de surface (12A) comporte une surface irrégulière au niveau d'une interface avec la couche d'absorption de lumière (17).

3. Dispositif laser à émission de surface selon la revendication 1 ou 2, dans lequel le film de réflexion de lumière (RF) est formé entre la couche d'absorption de lumière (17) et la plaque fluorescente (PL).

4. Dispositif laser à émission de surface selon l'une quelconque des revendications 1 à 3, dans lequel des plaques de conversion de longueur d'onde adjacentes de la pluralité de plaques de conversion de longueur d'onde (13A) sont en contact les unes avec les autres via le film de réflexion de la lumière (RF) sur la surface latérale de la plaque fluorescente (PL).

5. Dispositif laser à émission de surface selon l'une quelconque des revendications 1 à 4, dans lequel le réseau laser à émission de surface (12) comprend :
une couche de structure semiconductrice (SB) qui est commune aux éléments laser à émission de surface (12A) ;
des premier et deuxième miroirs réfléchissants multicouches (ML1, ML2) se faisant face l'un à l'autre avec la couche de structure semiconductrice (SB) interposée entre eux ; et
une couche de confinement de courant (CC) formée entre le premier miroir réfléchissant multicouche (ML1) et la couche de structure semiconductrice (SB) et comportant une pluralité de parties de confinement de courant (CP) correspondant aux éléments laser à émission de surface (12A), respectivement.

6. Dispositif laser à émission de surface selon la revendication 5, dans lequel :
la couche de confinement de courant (CC) est une couche isolante comportant une ouverture en tant que partie de confinement de courant (CP) ; et
l'ouverture de la couche isolante est agencée de façon coaxiale avec l'ouverture (AP) de la couche d'absorption de lumière (17).

7. Dispositif laser à émission de surface selon la revendication 6, dans lequel l'ouverture (AP) de la couche d'absorption de lumière (17) a un diamètre d'ouverture supérieur ou égal à un diamètre d'ouverture de l'ouverture de la couche isolante.
